# EUROPÄISCHE PATENTSCHRIFT

(11) **EP 3 503 343 B1**
(45) Veröffentlichungstag und Bekanntmachung des Hinweises auf die Patenterteilung: **07.07.2021**
(21) Anmeldenummer: 18210048.7
(22) Anmeldetag: 04.12.2018
(51) Int. Cl.: H02J 7/00, H02J 7/34, G01R 31/327

(54) **ELEKTRISCHES SYSTEM UND VERFAHREN ZUR DIAGNOSE DER FUNKTIONSFÄHIGKEIT VON LEISTUNGSRELAIS IN EINEM ELEKTRISCHEN SYSTEM**
ELECTRICAL SYSTEM AND METHOD FOR DIAGNOSING THE FUNCTIONALITY OF POWER RELAYS IN AN ELECTRICAL SYSTEM
SYSTÈME ÉLECTRIQUE ET PROCÉDÉ DE DIAGNOSTIC DE LA CAPACITÉ DE FONCTIONNEMENT DU RELAIS DE PUISSANCE DANS UN SYSTÈME ÉLECTRIQUE

(30) Priorität: 19.12.2017 DE 102017223229
(43) Veröffentlichungstag der Anmeldung: 26.06.2019
(73) Patentinhaber: VOLKSWAGEN AKTIENGESELLSCHAFT, 38440 Wolfsburg (DE)
(72) Erfinder: Müller, Jens Uwe, 34246 Vellmar (DE); Dang Hung, Lan, 30453 Hannover (DE); Stolz, Markus, 38471 Rühen (DE); Gerth, Dr. Hendrik, 30952 Ronnenberg (DE)

(56) Entgegenhaltungen:
- DE-A1-102006 050 529
- DE-A1-102015 209 081
- KR-A- 20140 136 844

## Beschreibung

Die Erfindung betrifft ein elektrisches System und ein Verfahren zur Diagnose der Funktionsfähigkeit von Leistungsrelais in einem elektrischen System.

Elektro- oder Hybridfahrzeuge verwenden hauptsächlich ein Batterie-, Brennstoffzellensystem oder dergleichen als Energiequelle für das Traktionsnetz, an dem eine oder mehrere Verbraucher über eine Leistungselektronik mit Zwischenkreiskapazität angeschlossen sind. Als Trennschalter zwischen Energiequelle und Traktionsnetz werden üblicherweise Relais, Schütze oder Halbleiter-Schalter in den beiden Verbindungsleitungen verwendet, um die Energieübertragung ab- oder zuschalten zu können. Das Zuschalten der Verbraucher mit Leistungselektronik und entladener Zwischenkreiskapazität durch Schließen der Schalter kann jedoch nicht ohne weitere Maßnahmen durchgeführt werden. Der aus dem geringen Innenwiderstand der Quelle (meist unterhalb von 1 Ohm) und des großen Potentialunterschieds resultierende Einschaltstrom kann zur thermischen Überbelastung, Schädigung bis hin zur Zerstörung einzelner Komponenten im Traktionsnetz führen.

Als Abhilfe dient die sogenannte Vorladeschaltung, z.B. eine Serienschaltung aus einem Schalter und einem Vorladewiderstand, die parallel zu einem Trennschalter angeordnet ist.

Dieser Schalter trennt den Pluspol der Quelle vom Anschluss zum Pluspol des Zwischenkreiskondensators, stellvertretend für alle Zwischenkreiskondensatoren im Traktionsnetz. Beim Starten des Fahrzeugs wird zunächst der gegenüberliegende Trennschalter, der zwischen dem Minuspol der Quelle und dem Anschluss zum Minuspol des Zwischenkreiskondensators angeordnet ist, geschlossen und danach der Schalter der Vorladeschaltung. Dank des Vorladewiderstandes zur Begrenzung der Stromspitze kann die Aufladung der Zwischenkreiskapazität kontrolliert vorgenommen werden, bis die Spannungsdifferenz zwischen der Energiequelle und den Verbrauchern einen Schwellwert (z.B. 10 V zum Schutz vor Überbeanspruchung oder Schädigung von herkömmlichen Schützen) unterschritten hat und der andere Trennschalter geschlossen werden kann. Danach kann der Schalter in der Vorladeschaltung wieder geöffnet werden.

Eine solche Vorladeschaltung ist beispielsweise aus der DE 10 2011 004 510 A1 bekannt. Diese offenbart eine elektrische Schaltung zur Diagnose von Schaltkontakten, insbesondere in einem batteriebetriebenen Straßenfahrzeug, bei der einer oder mehrere elektrische Schalter jeweils eingangsseitig und ausgangsseitig mit unterschiedlichen Anschlüssen einer Batteriesteuerungseinheit verbunden sind und bei der einer oder mehrere der Anschlüsse der Batteriesteuerungseinheit jeweils mit einem Messabgriff zur Erzeugung einer Messspannung bezüglich eines Referenzpotentials gekoppelt sind, wobei erste Mittel zum Einstellen der Messspannung auf einen vorbestimmten Spannungswert und/oder zweite Mittel zum Erzeugen und Messen eines Spannungsabfalls über ein mit einem der Schalter in Reihe geschalteten elektrischen Widerstandselement.

Aus der DE 10 2006 054 294 B4 ist ein Verfahren zum Überwachen eines elektrischen Relais in einer Schaltung bekannt, die elektrische Energie von einer Speichereinrichtung zu einer steuerbaren Lasteinrichtung leitet, bei dem zu dem elektrischen Relais permanent eine Widerstandseinrichtung parallel geschaltet wird. Dabei wird ein niedriger elektrischer Lastzustand an der Lasteinrichtung erkannt und die Lasteinrichtung angesteuert, bei einem bekannten Stromentnahmepegel zu arbeiten, wobei das Relais in die offene Stellung angesteuert wird. Weiter wird die elektrische Leistung an einem Knotenpunkt gemessen, der die Relaiseinrichtung, die steuerbare elektrische Lasteinrichtung und die Widerstandseinrichtung umfasst. Auf der Basis der an dem Knotenpunkt gemessenen elektrischen Leistung wird bestimmt, ob das in die offene Stellung angesteuerte Relais offen oder geschlossen ist.

Aus der WO 2014/090551 A2 ist eine Vorladeschaltung zum Laden eines Zwischenkreiskondensators bekannt, mit einem ersten elektronischen Bauteil, einem zweiten elektronischen Bauteil und einer Diagnoseeinrichtung, wobei die Diagnoseeinrichtung zur Funktionsprüfung des ersten und/oder zweiten elektronischen Bauteils ausgebildet ist und eine Energiequelle mit einer Klemmenspannung umfasst. Durch die Energiequelle ist ein Spannungsabfall an dem ersten elektronischen Bauteil hervorrufbar, wodurch die Funktionsfähigkeit des ersten elektronischen Bauteils und/oder des zweiten elektronischen Bauteils überprüfbar ist. Weiter weist die Diagnoseschaltung einen Diagnoseschalter auf, über den die Energiequelle derart mit dem ersten elektronischen Bauteil verschaltbar ist, dass die an dem ersten elektronischen Bauteil abfallende Spannung der Klemmenspannung entspricht.

Aus der DE 10 2014 219 395 A1 ist ein Fahrzeug bekannt, umfassend eine Traktionsbatterie, einen Schütz, der konfiguriert ist, die Traktionsbatterie und eine elektrische Impedanz zu verbinden, und eine Vorladeschaltung, die konfiguriert ist, um als Reaktion auf ein Schließsignal für den Schütz den Stromfluss von der Traktionsbatterie durch die Vorladeschaltung zu der elektrischen Impedanz zu steuern, um eine Spannung an der elektrischen Impedanz so zu vergrößern, dass, wenn sich die Spannung einer Spannung der Traktionsbatterie nähert, sich ein Auslastungsgrad der Vorladeschaltung 100 % nähert und sich der Strom durch die Vorladeschaltung Null nähert. Als Reaktion darauf, dass die Stromstärke unter einen vorbestimmten Wert fällt, wird der Schütz geschlossen.

Aus der DE 10 2006 050 529 A1 ist ein elektrisches System bekannt, umfassend mindestens eine Hochvoltbatterie, mindestens einen Zwischenkreiskondensator und mindestens zwei Leistungsrelais, wobei ein Leistungsrelais zwischen einem positiven Anschluss der Hochvoltbatterie und dem Zwischenkreiskondensator angeordnet ist und das andere Leistungsrelais zwischen einem negativen Anschluss der Hochvoltbatterie und dem Zwischenkreiskondensator angeordnet ist, wobei das elektrische System eine Diagnoseeinrichtung zur Überprüfung des Leistungsrelais aufweist, wobei die Diagnoseeinrichtung einen schaltbaren Spannungssensor parallel zur Hochvoltbatterie, mindestens eine schaltbare Energiequelle sowie mehrere Schalter aufweist.

Aus der KR 2014 0136844 A ist eine Diagnoseeinrichtung für Leistungsrelais bekannt. Diese weist eine erste Messeinrichtung auf, die die Spannung an einem mittleren Widerstand einer Reihenschaltung aus drei Widerständen erfasst. Die Reihenschaltung ist dabei über einen Schalter mit der positiven Hochvoltleitung verbunden und am anderen Ende mit der negativen Hochvoltleitung, wobei die Verbindungspunkte zwischen einer Hochvoltbatterie und den Leistungsrelais liegen. Des Weiteren ist eine zweite Messeinrichtung vorgesehen, die die Spannung an einem mittleren Widerstand einer Reihenschaltung aus drei Widerständen erfasst. Die Reihenschaltung ist dabei über einen Schalter mit der negativen Hochvoltleitung verbunden und am anderen Ende mit der positiven Hochvoltleitung, wobei die Verbindungspunkte zwischen den Leistungsrelais und einer elektrischen Last liegen. Des Weiteren ist ein Schaltelement zwischen den oberen Spannungsabgriffen der ersten und zweiten Messeinrichtung vorgesehen.

Aus der DE 10 2015 209 081 A1 ist ein gattungsgemäßes elektrisches System bekannt, umfassend mindestens eine Hochvoltbatterie, mindestens eine Niedervoltbatterie, einen zwischen den Batterien angeordneten DC/DC-Wandler, mindestens ein Leistungsrelais zwischen der Hochvoltbatterie und dem DC/DC-Wandler und mindestens einen Zwischenkreiskondensator, wobei das elektrische System mindestens eine Schaltung zur Vorladung des Zwischenkreiskondensators aufweist. Dabei ist die Schaltung als galvanisch getrennter DC/DC-Wandler ausgebildet, der mit einer Spannungsquelle im elektrischen System verbunden ist, wobei der DC/DC-Wandler derart ausgebildet ist, dass dieser elektrische Energie zum Vorladen des Zwischenkreiskondensators auf eine Hochvoltseite mit dem Zwischenkreiskondensator übertragen kann. Dabei kann der DC/DC-Wandler zwischen der Hochvoltbatterie und der Niedervoltbatterie als bidirektionaler DC/DC-Wandler ausgebildet sein, der dann zum Vorladen verwendet wird. Alternativ kann der DC/DC-Wandler als Tiefsetzsteller ausgebildet sein und parallel zum Leistungsrelais geschaltet sein.

Alternativ kann der DC/DC-Wandler als Hochsetzsteller ausgebildet sein, der in eine Hochvoltkomponente (z.B. einen Wechselrichter oder ein Ladegerät) integriert ist, wobei der DC/DC-Wandler mit der Niedervoltbatterie verbunden ist. Weiter ist mindestens eine Diagnoseeinheit vorhanden, die derart ausgebildet ist, dass die Energieübertragung zum Aufladen des Zwischenkreiskondensators ermittelt wird und daraus ein Zustand der Hochvoltseite ermittelt wird. Ein Problem dieses elektrischen Systems ist, dass die bisherigen Diagnosemöglichkeiten für die Leistungsrelais nicht mehr möglich sind.

Der Erfindung liegt das technische Problem zugrunde, ein elektrisches System zu schaffen, wo die Funktionsfähigkeit der Leistungsrelais überprüft werden kann, sowie ein geeignetes Verfahren zur Funktionsprüfung zur Verfügung zu stellen.

Die Lösung des technischen Problems ergibt sich durch ein elektrisches System mit den Merkmalen der Ansprüche 1,3, 4 und 5 sowie ein Verfahren mit den Merkmalen des Anspruchs 6. Weitere vorteilhafte Ausgestaltungen der Erfindung ergeben sich aus den Unteransprüchen. Hierzu umfasst das elektrische System mindestens eine Hochvoltbatterie, mindestens einen Zwischenkreiskondensator und mindestens zwei Leistungsrelais, wobei ein Leistungsrelais zwischen einem positiven Anschluss der Hochvoltbatterie und dem Zwischenkreiskondensator angeordnet ist und das andere Leistungsrelais zwischen einem negativen Anschluss der Hochvoltbatterie und dem Zwischenkreiskondensator angeordnet ist, wobei das elektrische System einen galvanisch getrennten DC/DC-Wandler aufweist, der mit einer Spannungsquelle im elektrischen System verbunden ist, wobei der DC/DC-Wandler derart ausgebildet ist, dass dieser elektrische Energie zum Vorladen des Zwischenkreiskondensators auf eine Hochvoltseite mit dem Zwischenkreiskondensator übertragen kann. Hinsichtlich der möglichen Ausgestaltungen des DC/DC-Wandlers wird auf die DE 10 2015 209 081 A1 verwiesen. Dabei sei angemerkt, dass der Begriff Leistungsrelais nicht einschränkend verstanden werden soll und beispielsweise auch Schütze einschließen soll. Der Begriff Hochvoltbatterie soll dabei auch Brennstoffzellen einschließen.

Weiter weist das elektrische System eine Diagnoseeinrichtung zur Überprüfung der Leistungsrelais auf, wobei die Diagnoseeinrichtung schaltbare Spannungssensoren aufweist. Dabei ist ein Spannungssensor parallel zur Hochvoltbatterie, ein Spannungssensor parallel zum Zwischenkreiskondensator, jeweils ein Spannungssensor parallel zu dem Leistungsrelais, ein Spannungssensor zwischen dem positiven Anschluss der Hochvoltbatterie und dem negativen Anschluss des Zwischenkreiskondensators und ein Spannungssensor zwischen dem negativen Anschluss der Hochvoltbatterie und einem Anschluss zwischen Leistungsrelais und positivem Anschluss des Zwischenkreiskondensators angeordnet. Dabei kann zwischen dem Leistungsrelais und dem positiven Anschluss des Zwischenkreiskondensators eine Sicherung angeordnet sein, wobei der Anschluss für den Spannungssensor zwischen Leistungsrelais und Sicherung dann liegt.

In einer alternativen Ausführungsform weist das elektrische System eine Diagnoseeinrichtung zur Überprüfung der Leistungsrelais auf, wobei die Diagnoseeinrichtung einen schaltbaren Spannungssensor parallel zur Hochvoltbatterie, mindestens eine schaltbare Energiequelle und mehrere Schalter aufweist.

Die Diagnoseeinrichtung kann dann gezielt die schaltbaren Spannungssensoren bzw. die Schalter in einer vorgegebenen Reihenfolge ansteuern, um so zunächst die Elemente der Diagnoseeinrichtung selbst zu überprüfen und schließlich dann die Funktionsfähigkeit der Leistungsrelais.

In einer Ausführungsform ist die schaltbare Energiequelle als Spannungsquelle ausgebildet, zu der in Reihe ein Widerstand geschaltet ist, wobei parallel zu Reihenschaltung von Widerstand und Spannungsquelle ein weiterer Widerstand und ein Spannungssensor angeordnet sind, wobei ein erster Schalter zwischen dem positiven Anschluss der Hochvoltbatterie und einem positiven Anschluss der schaltbaren Spannungsquelle liegt. Ein zweiter Schalter liegt zwischen dem positiven Anschluss der schaltbaren Spannungsquelle und dem negativen Anschluss des Zwischenkreiskondensators. Ein dritter Schalter liegt zwischen dem negativen Anschluss der schaltbaren Spannungsquelle und dem negativen Anschluss der Hochvoltbatterie. Ein vierter Schalter liegt zwischen dem negativen Anschluss der schaltbaren Spannungsquelle und einem Anschlusspunkt zwischen Leistungsrelais und positivem Anschluss des Zwischenkreiskondensators. Ein fünfter Schalter liegt in Reihe mit einem Widerstand parallel zu einer Sicherung, die zwischen dem Anschlusspunkt für den vierten Schalter und dem positiven Anschluss des Zwischenkreiskondensators liegt. Hierdurch wird die Anzahl der Spannungssensoren reduziert und durch einfache Schalter ersetzt.

In einer alternativen Ausführungsform ist die schaltbare Energiequelle als Stromquelle ausgebildet, zu der parallel ein Spannungssensor angeordnet ist. Dabei liegt ein erster Schalter zwischen dem positiven Anschluss der Hochvoltbatterie und einem positiven Anschluss der schaltbaren Stromquelle. Ein zweiter Schalter ist zwischen dem positiven Anschluss der schaltbaren Stromquelle und einem negativen Anschluss des Zwischenkreiskondensators angeordnet. Ein dritter Schalter liegt zwischen dem negativen Anschluss der schaltbaren Stromquelle und einem negativen Anschluss der Hochvoltbatterie. Ein vierter Schalter liegt zwischen dem negativen Anschluss der schaltbaren Stromquelle und einem Anschlusspunkt zwischen dem Leistungsrelais und einem positiven Anschluss des Zwischenkreiskondensators. Ein fünfter Schalter in Reihe mit einem Widerstand liegt zwischen dem Anschluss des vierten Schalters und dem negativen Anschluss des Zwischenkreiskondensators. Der Vorteil gegenüber der Ausführungsform mit schaltbarer Spannungsquelle ist, dass zwei Widerstände weniger benötigt werden.

In einer alternativen Ausführungsform ist die schaltbare Energiequelle die Hochvoltbatterie, wobei parallel zu dem Leistungsrelais am positiven Anschluss ein erster Schalter und ein zweiter Schalter angeordnet sind und parallel zum Leistungsrelais am negativen Anschluss ein dritter Schalter und ein vierter Schalter angeordnet sind, wobei zwischen den Mittelabgriffen zwischen dem ersten und zweiten Schalter sowie dritten und vierten Schalter ein Spannungssensor mit parallel geschaltetem Widerstand angeordnet ist. Weiter ist parallel zum Leistungsrelais am positiven Anschluss der Hochvoltbatterie ein fünfter Schalter mit einem in Reihe geschalteten Widerstand angeordnet sowie parallel zum Leistungsrelais am negativen Anschluss der Hochvoltbatterie ein sechster Schalter mit einem in Reihe geschalteten Widerstand angeordnet, wobei zwischen dem Mittelabgriff zwischen dem ersten und zweiten Schalter und einem positiven Anschluss des Zwischenkreiskondensators ein siebenter Schalter in Reihe mit einem Widerstand angeordnet ist.

Die Erfindung wird nachfolgend anhand bevorzugter Ausführungsbeispiele näher erläutert. Die Figuren zeigen:
- Fig. 1: ein elektrisches System in einer ersten Ausführungsform,
- Fig. 2: ein elektrisches System in einer zweiten Ausführungsform,
- Fig. 3: ein elektrisches System in einer dritten Ausführungsform und
- Fig. 4: ein elektrisches System in einer vierten Ausführungsform.

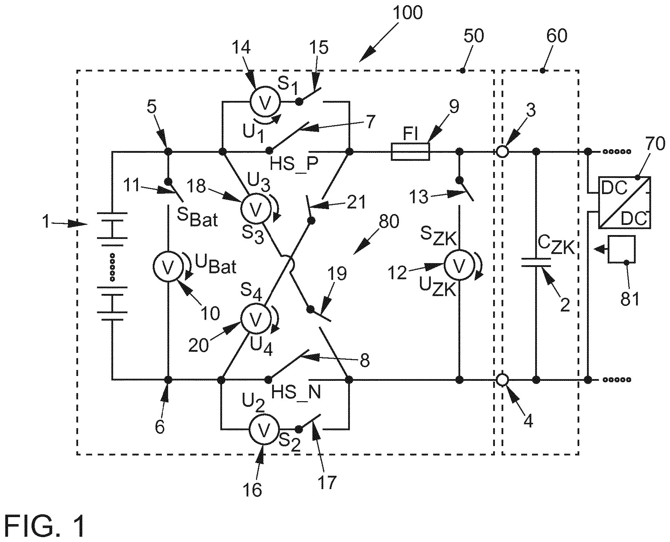

In der Fig. 1 ist ein elektrisches System 100 in einer ersten Ausführungsform dargestellt. Das elektrische System 100 umfasst eine Hochvoltenergiequelle 50 und ein Traktionsnetz 60 mit einem Zwischenkreiskondensator 2. Weiter umfasst das elektrische System 100 einen galvanisch getrennten DC/DC-Wandler 70 zum Verladen des Zwischenkreiskondensators 2 sowie eine Diagnoseeinrichtung 80. Die Diagnoseeinrichtung 80 umfasst eine Steuereinheit 81 sowie sechs schaltbare Spannungssensoren S_{Bat}, S_{ZK}, S1-S4.

Die Hochvoltenergiequelle 50 umfasst eine Hochvoltbatterie 1, die aus einer Vielzahl von Batteriezellen besteht, die einen positiven Pol bzw. positiven Anschluss 5 und einen negativen Pol bzw. negativen Anschluss 6 aufweist. Am positiven Pol 5 ist ein Leistungsrelais 7 angeordnet, das zwischen dem positiven Pol 5 und einem positiven Pol bzw. Anschluss 3 des Zwischenkreiskondensators 2 angeordnet ist, wobei zusätzlich noch eine Sicherung 9 in Reihe geschaltet ist. Entsprechend ist zwischen dem negativen Pol 6 der Hochvoltbatterie 2 und einem negativen Anschluss 4 des Zwischenkreiskondensators 2 ein zweites Leistungsrelais 8 angeordnet. Dabei ist ein schaltbarer Spannungssensor S_{BAT} parallel zur Hochvoltbatterie 1 angeordnet und umfasst einen Schalter 11 und einen Spannungssensor 10. Ein weiterer schaltbarer Spannungssensor S_ZK ist parallel zum Zwischenkreiskondensator 2 angeordnet und umfasst einen Schalter 13 und einen Spannungssensor 12. Der schaltbare Spannungssensor S1 mit Schalter 15 und Spannungssensor 14 ist parallel zum ersten Leistungsrelais 7 angeordnet. Der schaltbare Spannungssensor S2 mit Schalter 17 und Spannungssensor 16 ist parallel zum zweiten Leistungsrelais 8 angeordnet. Ein weiterer schaltbarer Spannungssensor S3 mit Schalter 19 und Spannungssensor 18 ist zwischen dem positiven Pol 5 und dem negativen Anschluss 4 angeordnet. Schließlich ist ein schaltbarer Spannungssensor S4 mit Schalter 21 mit Spannungssensor 20 zwischen dem negativen Pol 6 und einem Anschluss zwischen erstem Leistungsrelais 7 und Sicherung 9 angeordnet.

Zur Gewährleistung der funktionalen Sicherheit beim Zu- und Abschalten des Traktionsnetzes 60 von der Hochvoltenergiequelle 50 müssen nicht nur die Zustände der Leistungsrelais 7, 8, sondern auch die der schaltbaren Spannungssensoren S_{Bat}, S_{ZK}, S1-S4 und der Sicherung 9 vorher plausibilisiert werden.

In einem ersten Initialschritt wird der Schalter 11 geschlossen, wobei dann der Spannungssensor 10 die Spannung U_{Bat} der Hochvoltbatterie 1 messen müsste. Diese Spannung kann dann mit Hilfe der erfassten Einzelspannungen der Batteriezellen, die ohnehin erfasst wird, plausibilisiert werden. Ist die Abweichung von U_{Bat} zur Summe der Einzelspannungen der Batteriezellen kleiner als ein Schwellwert (z.B. 10 V), so arbeitet der schaltbare Spannungssensor S_{Bat} einwandfrei.

Zur Diagnose der übrigen schaltbaren Spannungssensoren S1-S4, S_{ZK} sowie der Sicherung 9 stehen insgesamt sieben Maschengleichungen zur Verfügung. Damit können die Funktionalität aller Elemente eindeutig überprüft werden. Ausgehend vom Initialzustand bei dem S_{Bat} plausibilisiert wurde und dessen Schalter 11 geschlossen ist sowie alle anderen Schalter geöffnet sind, werden alle restlichen Elemente einzeln nacheinander oder zusammen überprüft.

| | |
|---|---|
| 1. Masche: | Schalter 17 und 19 sind geschlossen. Maschenumlauf über S_{Bat} (10), S3 (18) und S2 (16). Die Summe der Spannungen soll Null sein oder unterhalb eines Schwellwerts (z. B. 3 x 5 V = 15 V bei +/-2,5 V Messtoleranz der einzelnen Sensoren) liegen. |
| 2. Masche: | Schalter 15 und 21 sind geschlossen. Maschenumlauf über S_{Bat} (10), S1 (14) und S4 (20). Die Summe der Spannungen soll Null sein oder unterhalb eines Schwellwerts (z. B. 3 x 5 V = 15 V bei +/-2,5 V Messtoleranz der einzelnen Sensoren) liegen. |
| 3. Masche: | Schalter 13, 15 und 17 sind geschlossen. Maschenumlauf über S_{Bat} (10), S1 (14), FI (9), S_{ZK} (12) und S2 (16). Die Summe der Spannungen soll Null sein oder unterhalb eines Schwellwerts (z. B. 4 x 5 V = 20 V bei +/-2,5 V Messtoleranz der einzelnen Sensoren) liegen. |
| 4. Masche: | Schalter 13, 15 und 19 sind geschlossen. Maschenumlauf über S3 (18), S1 (14), FI (9) und S_{ZK} (12). Die Summe der Spannungen soll Null sein oder unterhalb eines Schwellwerts (z. B. 3 x 5 V = 15 V bei +/-2,5 V Messtoleranz der einzelnen Sensoren) liegen. |
| 5. Masche: | Schalter 13, 17 und 21 sind geschlossen. Maschenumlauf über S4 (20), FI (9), S_{ZK} (12) und S2 (16). Die Summe der Spannungen soll Null sein oder unterhalb eines Schwellwerts (z.B. 3 x 5 V = 15 V bei +/-2,5 V Messtoleranz der einzelnen Sensoren) liegen. |
| 6. Masche: | Schalter 13, 19 und 21 sind geschlossen. Maschenumlauf über S_{Bat} (10), S3 (18), S_{ZK} (12), FI (9) und S4 (20). Die Summe der Spannungen soll Null sein oder unterhalb eines Schwellwerts (z.B. 4 x 5 V = 20 V bei +/-2,5 V Messtoleranz der einzelnen Sensoren) liegen. |
| 7. Masche: | Schalter 15, 17, 19 und 21 sind geschlossen. Maschenumlauf über S1 (14), S4 (20), S2 (16) und S3 (18). Die Summe der Spannungen soll Null sein oder unterhalb eines Sehwellwerts (z. B. 4 x 5 V = 20 V bei +/-2,5 V Messtoleranz der einzelnen Sensoren) liegen. |

Sobald alle schaltbaren Spannungssensoren plausibilisiert sind, können die beiden Leistungsrelais 7, 8 diagnostiziert werden. Ist eines der beiden verklebt, so misst der parallel anliegende Spannungssensor 14 bzw. 16 eine Spannung unterhalb eines vorgegebenen Schwellwerts (von z.B. 5 V).

Der Vorteil dieser Schaltung ist, dass diese sehr schnell ist, da der Zwischenkreiskondensator 2 nicht geladen bzw. umgeladen werden muss. Die Schalter 11, 13, 15, 17, 19, 21 können dabei als diskrete Halbleiterschalter oder als Relais ausgebildet sein.

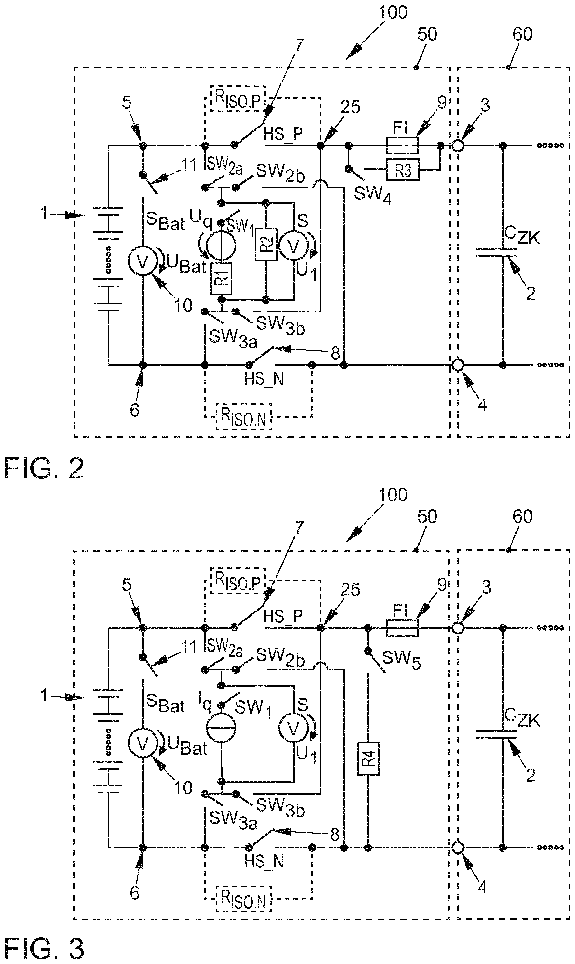

In der Fig. 2 ist eine alternative Ausführungsform eines elektrischen Systems 100 dargestellt, wobei gleiche Elemente wie in Fig. 1 mit gleichen Bezugszeichen versehen sind. Die Schaltung weist wieder einen schaltbaren Spannungssensor S_{Bat} auf sowie fünf Schalter SW₂ₐ, SW_{2b}, SW₃ₐ, SW_{3b}, SW₄, eine potentialfreie schaltbare Spannungsquelle U_{q} mit einem Schalter SW₁ und einen potentialfreien Spannungssensor S auf. In Reihe zum Schalter SW₁ der schaltbaren Spannungsquelle U_{q} ist ein Widerstand R1 geschaltet. Ein weiterer Widerstand R2 ist parallel zu der Reihenschaltung von Schalter SW₁, Spannungsquelle U_{q} und Widerstand R1 geschaltet. Der erste Schalter SW₂ₐ liegt zwischen dem positiven Pol 5 der Hochvoltbatterie 1 sowie dem positiven Anschluss der Spannungsquelle U_{q}. Der zweite Schalter SW_{2b} liegt zwischen dem positiven Anschluss der Spannungsquelle U_{q} und dem negativen Anschluss 4 des Zwischenkreiskondensators. Der dritte Schalter SW₃ₐ liegt zwischen dem Widerstand R1 der Spannungsquelle U_{q} und dem negativen Pol 6 der Hochvoltbatterie 1. Der vierte Schalter SW_{3b} liegt zwischen dem Widerstand R1 der Spannungsquelle U_{q} und einem Anschluss 25 zwischen erstem Leistungsrelais 7 und Sicherung 9. Der fünfte Schalter SW₄ liegt in Reihe mit einem Widerstand R3 parallel zur Sicherung 9.

Es wird wieder vom Initialzustand (nur Sensor S_{Bat} ist zugeschaltet und plausibilisiert) ausgegangen. Durch das Schließen der Schalter SW₂ₐ und SW₃ₐ bleibt die Spannungsquelle U_{q} weiterhin vom Rest der Schaltung entkoppelt und der Sensor S ist nun direkt mit der Hochvoltbatterie 1 verbunden. Damit misst der Sensor S ebenfalls die gesamte Hochvoltspannung. Ist die Spannungsdifferenz zwischen den beiden Sensoren S_{Bat}, S kleiner als ein definierter Schwellwert (z.B. 10 V) ist die Funktionalität des Sensors S und der Schalter SW₂ₐ sowie SW₃ₐ gewährleistet. Zusätzlich können durch ein sequentielles Öffnen/Schließen die Schalter SW₂ₐ und SW₃ₐ hinsichtlich Öffnen/Schließen diagnostiziert werden. Bleibt einer der Schalter dauerhaft offen, kann der Schwellwert (z.B. 10 V) nie unterschritten werden. Ist dagegen einer der beiden Schalter dauerhaft geschlossen, bleibt die obige Bedingung bei einem vermeintlichen Öffnen des jeweiligen Schalters stets erfüllt. In beiden Fällen wird ein Fehler des Messsystems erkannt. Da der Widerstand R2 parallel zum Sensor S liegt, fällt die komplette Quellenspannung an diesem Widerstand ab. Zur Begrenzung der im R2 anfallenden Verluste sollte dieser vorzugsweise mindestens 1 MOhm groß sein.

Als nächster Schritt werden SW₂ₐ und SW₃ₐ wieder geöffnet und SW₁ geschlossen. Damit prägt die Spannungsquelle U_{q} einen Spannungsabfall über den beiden Widerständen R1 und R2 ein. Entsprechend des Spannungsteilerverhältnisses stellt sich eine Spannung am Widerstand R2 ein, die mit dem Sensor S messbar ist, wenn Spannungsquelle U_{q} und Schalter SW₁ korrekt funktionieren.

Zusätzlich zum Schalter SW₁ werden die Schalter SW_{2b} und SW_{3b} sequentiell geschlossen. Dadurch liegt der positive Anschluss der Spannungsquelle am Minuspol und der negative Anschluss mit dem Widerstand R1 am Pluspol des Zwischenkreiskondensators 2.

Funktionieren die Schalter fehlerfrei, wird der Zwischenkreiskondensator umgeladen. Ist der Kondensator zuvor ladungsfrei, so steigt die Zwischenkreisspannung betragsmäßig von Null Richtung |U_{q}*R2/(R1+R2)| an. Die Spannung am Sensor S fällt ebenfalls zum Zeitpunkt des Zuschaltens beider Schalter vom Wert U_{q}*R2/(R1+R2) auf Null und steigt wie die Spannung am Zwischenkreis wieder Richtung des ursprünglichen Werts von U_{q}*R2/(R1+R2) an. Die Wertauslegung für die Spannungsquelle und den Widerstand R1 hängen maßgeblich von der Größe der Zwischenkreiskapazität und der Messtoleranz des Sensors S ab. Die Spannungsquelle U_{q} sollte eine Spannung liefern, die mindestens um Faktor drei größer als die Messtoleranz des Sensors S beträgt. Damit die Zwischenkreisspannung schnell auf eine messbare Spannung aufgeladen werden kann, darf der Widerstand R1 als Strombegrenzer nicht zu groß gewählt werden. Eine Spannungsquelle mit 12 V braucht beispielsweise bei einer Zwischenkreiskapazität von 500 µF und einem Widerstand R1 von 100 Ohm etwa 27 ms, um auf 5 V, und etwa 90 ms, um auf 10 V aufzuladen. Es gilt dabei, die Dauer der Diagnose so kurz wie möglich zu halten. In dieser Zeit kann zusätzlich zur Plausibilisierung der Sicherung 9 und des Schalters SW₄ der Schalter selber geschlossen und wieder geöffnet werden. Beim Schließen des Schalters wird der Zwischenkreiskondensator aufgrund des zusätzlichen Widerstands R3 langsamer aufgeladen als beim Stromfluss durch die Sicherung im geöffneten Zustand. Um den Unterschied gut zu erkennen, sollte R3 mindestens doppelt so groß wie R1 sein.

Nach der erfolgreichen Plausibilisierung aller Sensoren und Hilfsschalter können die Leistungsrelais 7, 8 überprüft werden. Es wird dabei auch der Isolationswiderstand R_{iso,P}. R_{iso,N}, der sich aus einem Teilwiderstand zwischen dem einen Anschlusspunkt des jeweiligen Leistungsrelais 7, 8 und dem Gehäuse der Spannungsquelle U_{q} sowie einem Teilwiderstand zwischen dem Gehäuse und dem anderen Anschlusspunkt desselben Leistungsrelais 7, 8 zusammensetzt, berücksichtigt. Dazu werden die Schalter SW₁, SW₂ₐ und SW_{3b} geschlossen und alle anderen geöffnet. Bei dem offenen, positiven Leistungsrelais 7 und einem Isolationsfehler, wo R_{iso,P} deutlich kleiner als z. B. 10 MOhm ist, misst der Sensor S eine Spannung von U_{q}*(R2∥R_{iso,P})/(R1+(R2∥R_{iso,P})), da jetzt ein nicht vernachlässigbarer Isolationswiderstand parallel zum Widerstand R2 anliegt und damit den Spannungsteiler verändert hat. Liegt dagegen kein Isolationsfehler am positiven Leistungsrelais 7 vor, misst der Sensor S weiterhin eine Spannung von U_{q}*R2/(R1+R2). Im Fall eines Verklebens des Leistungsrelais 7 wird der Sensor S über diesen kurzgeschlossen, was als Fehler erkannt wird. Analog werden zur Plausibilisierung des negativen Leistungsrelais 8 ausschließlich die Schalter SW₁, SW_{2b} und SW₃ₐ geschlossen. Auch hier muss der Sensor S im fehlerfreien Fall eine Spannung von U_{q}*R2/(R1+R2) messen können.

Damit ergibt sich folgende beispielhafte Diagnosereihenfolge beim Starten des Fahrzeugs, bevor das Traktionsnetz zugeschaltet wird:
1. Alle Schalter (außer 11) sind zunächst offen.
2. Schalter SW₂ₐ schließen, dann Schalter SW₃ₐ schließen und danach Schalter SW₂ₐ öffnen (SW₂ₐ, SW₃ₐ und Sensor S plausibilisieren).
3. Schalter SW₃ₐ öffnen und gleichzeitig Schalter SW₁ schließen (Spannungsquelle U_{q} plausibilisieren).
4. Schalter SW_{2b} schließen und dann Schalter SW_{3b} schließen (SW_{2b} und SW_{3b} plausibilisieren).
5. Gegebenenfalls Schalter SW₄ schließen (Sicherung und SW₄ plausibilisieren).
6. Schalter SW_{2b} öffnen und gleichzeitig Schalter SW₂ₐ schließen (Leistungsrelais 7 plausibilisieren).
7. Schalter SW₂ₐ öffnen und gleichzeitig Schalter SW_{2b} schließen, dann Schalter SW_{3b} öffnen und gleichzeitig Schalter SW₃ₐ schließen (Leistungsrelais 8 plausibilisieren).
8. Alle Schalter (außer 11) werden wieder geöffnet.

Diese Schaltung bietet außerdem noch den Vorteil, dass mit Hilfe des Sensors S die Spannung des Zwischenkreiskondensators während des Vorladens erfasst und für die Regelung des DC/DC-Wandlers verwendet werden kann.

In der Fig. 3 ist eine dritte Ausführungsform eines elektrischen Systems 100 dargestellt, die weitgehend der Schaltung gemäß Fig. 2 entspricht. Der Unterschied besteht darin, dass die Spannungsquelle U_{q} und die Widerstände R1, R2 durch eine schaltbare Stromquelle I_{q} ersetzt wird. Des Weiteren wird der fünfte Schalter SW₄ mit einem Widerstand R3 ersetzt durch einen Schalter SW₅ mit einem Widerstand R4, die zwischen dem Anschlusspunkt 25 und dem negativen Anschluss 4 des Zwischenkreiskondensators 2 liegen.

Funktions- und Vorgehensweise sind aber ähnlich. Die Plausibilisierung der Schalter SW_{2b} und SW_{3b} wird mittels des zuschaltbaren Widerstands R4 durchgeführt. Die Sicherung 9 wird dagegen bei der kurzzeitigen Aufladung des Zwischenkreiskondensators 2 durch die Stromquelle I_{q} nach dem Schließen der Schalter SW_{2b} und SW_{3b} überprüft. Ist einer der beiden Leistungsrelais 7, 8 verklebt, würde die Stromquelle beim Zuschalten durch diesen kurzgeschlossen und der Sensor S würde diesen Fehler detektieren.

Der Grundgedanke der beiden obigen Schaltungen ist die Diagnosemöglichkeit der Leistungsrelais 7, 8 durch eine geeignete Zuschaltung einer aktiven Quelle an die beiden Leistungsrelais, um deren Zustand zu erfassen.

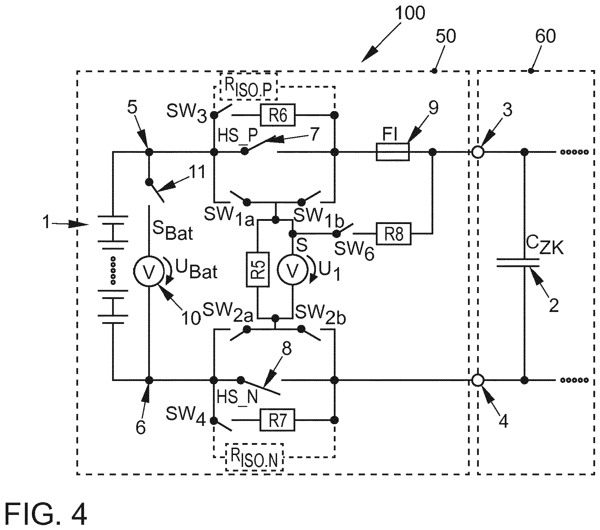

In der Fig. 4 ist eine weitere alternative Ausführungsform dargestellt, wobei im Unterschied zu Fig. 2 und Fig. 3 die Hochvoltbatterie 1 die schaltbare Energiequelle ist, wobei jedoch eine höhere Anzahl von Schaltern und Widerständen benötigt werden.

Folgende Diagnosereihenfolge kann mit dieser Schaltung realisiert werden:
1. Initialzustand herstellen (nur Sensor S_{Bat} ist zugeschaltet und bereits plausibilisiert).
2. Schalter SW₁ₐ und Schalter SW₂ₐ nacheinander schließen und wieder öffnen (SW₁ₐ, SW₂ₐ und Sensor S plausibilisieren).
3. Schalter SW₁ₐ schließen. Schalter SW₂ₐ öffnen, dann Schalter SW_{2b} schließen und kurz danach Schalter SW₄ ebenfalls schließen (SW_{2b}, SW₄ und Leistungsrelais 8 plausibilisieren). Ist das Leistungsrelais 8 verschweißt, liegt die Batteriespannung unmittelbar nach dem Schließen des Schalters SW_{2b} am Sensor S an. Ist das Leistungsrelais 8 dagegen offen, aber es liegt ein Isolationsfehler vor, bilden die Widerstände R5 und R_{iso,N} einen Spannungsteiler über der Quelle. Da der Isolationswiderstand nicht bekannt ist, wird durch den Schalter SW₄ ein definierter Widerstand zugeschaltet, um eine Spannungsänderung am Sensor S hervorzurufen und damit den Fehler zu erkennen. Ist das Leistungsrelais 8 offen und es liegt kein Isolationsfehler vor, kann der Sensor S erst beim Schließen der Schalter SW_{2b}, SW₄ einen definierten Spannungswert von U_{Bat}. R5 / (R5+R7) erfassen.
4. Schalter SW₁ₐ, SW_{2b} und SW₄ werden geöffnet, dann Schalter SW₂ₐ, SW_{1b} und anschließend Schalter SW₃ geschlossen (SW₂ₐ, SW₃ und Leistungsrelais 7 plausibilisieren).
5. Schalter SW_{1b} öffnen und dann Schalter SW₆ schließen (SW₆ und Sicherung plausibilisieren).

Zur Verlustminimierung sollen die Widerstände große Werte (z.B. 1 MOhm) besitzen. Da alle Schalter die Energiequelle ab- und zuschalten, müssen sie für die an der Quelle anliegende Spannung ausgelegt sein.

## Patentansprüche

1. Elektrisches System (100), umfassend mindestens eine Hochvoltbatterie (1), mindestens einen Zwischenkreiskondensator (2) und mindestens zwei Leistungsrelais (7, 8), wobei ein Leistungsrelais (7) zwischen einem positiven Anschluss (5) der Hochvoltbatterie (1) und dem Zwischenkreiskondensator (2) angeordnet ist und das andere Leistungsrelais (8) zwischen einem negativen Anschluss (6) der Hochvoltbatterie (1) und dem Zwischenkreiskondensator (2) angeordnet ist, wobei das elektrische System (100) einen galvanisch getrennten DC/DC-Wandler (70) aufweist, der mit einer Spannungsquelle im elektrischen System (100) verbunden ist, wobei der DC/DC-Wandler (70) derart ausgebildet ist, dass dieser elektrische Energie zum Verladen des Zwischenkreiskondensators (2) auf eine Hochvoltseite mit dem Zwischenkreiskondensator (2) übertragen kann,
**dadurch gekennzeichnet, dass**
das elektrische System (100) eine Diagnoseeinrichtung (80) zur Überprüfung der Leistungsrelais (7, 8) aufweist, wobei die Diagnoseeinrichtung (80) schaltbare Spannungssensoren (S_{Bat}, S_{ZK}, S1-S4) aufweist, wobei ein Spannungssensor (S_{Bac}) parallel zur Hochvoltbatterie (1), ein Spannungssensor (S_{ZK}) parallel zum Zwischenkreiskondensator (2), jeweils ein Spannungssensor (S1, S2) parallel zu den Leistungsrelais (7, 8), ein Spannungssensor (S3) zwischen dem positiven Anschluss (5) der Hochvoltbatterie (1) und dem negativen Anschluss (4) des Zwischenkreiskondensators (2) und ein Spannungssensor (S4) zwischen dem negativen Anschluss (6) der Hochvoltbatterie (1) und einem Anschluss zwischen Leistungsrelais (7) und positivem Anschluss (3) des Zwischenkreiskondensators (2) angeordnet ist.

2. Elektrisches System nach Anspruch 1, **dadurch gekennzeichnet, dass** zwischen dem Leistungsrelais (7) und dem positiven Anschluss (3) des Zwischenkreiskondensators (2) eine Sicherung (9) angeordnet ist, wobei der Anschluss für den Spannungssensor (S4) zwischen Leistungsrelais (7) und Sicherung (9) liegt.

3. Elektrisches System, umfassend mindestens eine Hochvoltbatterie (1), mindestens einen Zwischenkreiskondensator (2) und mindestens zwei Leistungsrelais (7, 8), wobei ein Leistungsrelais (7) zwischen einem positiven Anschluss (5) der Hochvoltbatterie (1) und dem Zwischenkreiskondensator (2) angeordnet ist und das andere Leistungsrelais (8) zwischen einem negativen Anschluss (6) der Hochvoltbatterie (1) und dem Zwischenkreiskondensator (2) angeordnet ist, wobei das elektrische System (100) einen galvanisch getrennten DC/DC-Wandler (70) aufweist, der mit einer Spannungsquelle im elektrischen System (100) verbunden ist, wobei der DC/DC-Wandler (70) derart ausgebildet ist, dass dieser elektrische Energie zum Verladen des Zwischenkreiskondensators (2) auf eine Hochvoltseite mit dem Zwischenkreiskondensator (2) übertragen kann,
**dadurch gekennzeichnet, dass**
das elektrische System (100) eine Diagnoseeinrichtung (80) zur Überprüfung der Leistungsrelais (7, 8) aufweist, wobei die Diagnoseeinrichtung (80) einen schaltbaren Spannungssensor (S_{Bat}) parallel zur Hochvoltbatterie (1), mindestens eine schaltbare Energiequelle (U_{q}, I_{q}, 1) sowie mehrere Schalter aufweist, wobei
die schaltbare Energiequelle als Spannungsquelle (U_{q}) ausgebildet ist, zu der in Reihe ein
Widerstand (R1) geschaltet ist, wobei parallel zur Reihenschaltung von Widerstand (R1) und Spannungsquelle (U_{q}) ein weiterer Widerstand (R2) und ein Spannungssensor (5) angeordnet sind, wobei ein erster Schalter (SW₂ₐ) zwischen dem positiven Anschluss (5) der Hochvoltbatterie (1) und einem positiven Anschluss der schaltbaren Spannungsquelle (U_{q}) liegt, ein zweiter Schalter (SW_{2b}) zwischen dem positiven Anschluss der schaltbaren Spannungsquelle (U_{q}) und dem negativen Anschluss (4) des Zwischenkreiskondensators (2), ein dritter Schalter (SW₃ₐ) zwischen dem negativen Anschluss der schaltbaren Spannungsquelle (U_{q}) und dem negativen Anschluss (6) der Hochvoltbatterie (1), ein vierter Schalter (SW_{3b}) zwischen dem negativen Anschluss der schaltbaren Spannungsquelle (U_{q}) und einem Anschlusspunkt (25) zwischen Leistungsrelais (7) und positivem Anschluss (3) des Zwischenkreiskondensators (2) und ein fünfter Schalter (SW₄) in Reihe mit einem Widerstand (R3) parallel zu einer Sicherung (9) angeordnet ist, die zwischen dem Anschlusspunkt (25) für den vierten Schalter (SW_{3b}) und dem positiven Anschluss (3) des Zwischenkreiskondensators (2) liegt.

4. Elektrisches System, umfassend mindestens eine Hochvoltbatterie (1), mindestens einen Zwischenkreiskondensator (2) und mindestens zwei Leistungsrelais (7, 8), wobei ein Leistungsrelais (7) zwischen einem positiven Anschluss (5) der Hochvoltbatterie (1) und dem Zwischenkreiskondensator (2) angeordnet ist und das andere Leistungsrelais (8) zwischen einem negativen Anschluss (6) der Hochvoltbatterie (1) und dem Zwischenkreiskondensator (2) angeordnet ist, wobei das elektrische System (100) einen galvanisch getrennten DC/DC-Wandler (70) aufweist, der mit einer Spannungsquelle im elektrischen System (100) verbunden ist, wobei der DC/DC-Wandler (70) derart ausgebildet ist, dass dieser elektrische Energie zum Verladen des Zwischenkreiskondensators (2) auf eine Hochvoltseite mit dem Zwischenkreiskondensator (2) übertragen kann,
**dadurch gekennzeichnet, dass**
das elektrische System (100) eine Diagnoseeinrichtung (80) zur Überprüfung der Leistungsrelais (7, 8) aufweist, wobei die Diagnoseeinrichtung (80) einen schaltbaren Spannungssensor (SBat) parallel zur Hochvoltbatterie (1), mindestens eine schaltbare Energiequelle (Uq, Iq, 1) sowie mehrere Schalter aufweist, wobei die schaltbare Energiequelle als Stromquelle (I_{q}) ausgebildet ist, zu der parallel ein Spannungssensor (S) angeordnet ist, wobei ein erster Schalter (SW₂ₐ) zwischen dem positiven Anschluss (5) der Hochvoltbatterie (1) und einem positiven Anschluss der schaltbaren Stromquelle (I_{q}) liegt, ein zweiter Schalter (SW_{2b}) zwischen dem positiven Anschluss der schaltbaren Stromquelle (I_{q}) und einem negativen Anschluss (4) des Zwischenkreiskondensators (2) liegt, ein dritter Schalter (SW₃ₐ) zwischen dem negativen Anschluss der schaltbaren Stromquelle (I_{q}) und einem negativen Anschluss der Hochvoltbatterie (6) liegt, ein vierter Schalter (SW_{3b}) zwischen dem negativen Anschluss der schaltbaren Stromquelle (I_{q}) und einem Anschlusspunkt (25) zwischen dem Leistungsrelais (7) und einem positiven Anschluss (3) des Zwischenkreiskondensators (2) liegt, ein fünfter Schalter (SW₅) in Reihe mit einem Widerstand (R4) zwischen dem Anschlusspunkt (25) des vierten Schalters (SW_{3b}) und dem negativen Anschluss (4) des Zwischenkreiskondensators (2) liegt.

5. Elektrisches System, umfassend mindestens eine Hochvoltbatterie (1), mindestens einen Zwischenkreiskondensator (2) und mindestens zwei Leistungsrelais (7, 8), wobei ein Leistungsrelais (7) zwischen einem positiven Anschluss (5) der Hochvoltbatterie (1) und dem Zwischenkreiskondensator (2) angeordnet ist und das andere Leistungsrelais (8) zwischen einem negativen Anschluss (6) der Hochvoltbatterie (1) und dem Zwischenkreiskondensator (2) angeordnet ist, wobei das elektrische System (100) einen galvanisch getrennten DC/DC-Wandler (70) aufweist, der mit einer Spannungsquelle im elektrischen System (100) verbunden ist, wobei der DC/DC-Wandler (70) derart ausgebildet ist, dass dieser elektrische Energie zum Verladen des Zwischenkreiskondensators (2) auf eine Hochvoltseite mit dem Zwischenkreiskondensator (2) übertragen kann,
**dadurch gekennzeichnet, dass**
das elektrische System (100) eine Diagnoseeinrichtung (80) zur Überprüfung der Leistungsrelais (7, 8) aufweist, wobei die Diagnoseeinrichtung (80) einen schaltbaren Spannungssensor (S_{Bat}) parallel zur Hochvoltbatterie (1), mindestens eine schaltbare Energiequelle (U_{q}, I_{q}, 1) sowie mehrere Schalter aufweist, wobei die schaltbare Energiequelle die Hochvoltbatterie (1) ist, wobei parallel zu dem Leistungsrelais (7) am positiven Anschluss (5) ein erster Schalter (SW₁ₐ) und ein zweiter Schalter (SW_{1b}) angeordnet sind und parallel zum Leistungsrelais (8) am negativen Anschluss (6) ein dritter Schalter (SW₂ₐ) und ein vierter Schalter (SW_{2b}) angeordnet sind, wobei zwischen den Mittelabgriffen zwischen dem ersten und zweiten Schalter sowie dritten und vierten Schalter ein Spannungssensor (S) mit parallel geschaltetem Widerstand (R5) angeordnet ist, wobei parallel zum Leistungsrelais (7) am positiven Anschluss (5) der Hochvoltbatterie (1) ein fünfter Schalter (SW₃) mit einem in Reihe geschalteten Widerstand (R6) angeordnet ist, und parallel zum Leistungsrelais (8) am negativen Anschluss (6) der Hochvoltbatterie (1) ein sechster Schalter (SW₄) mit einem in Reihe geschalteten Widerstand (R7) angeordnet ist, wobei zwischen dem Mittelabgriff zwischen dem ersten und zweiten Schalter und einem positiven Anschluss (3) des Zwischenkreiskondensators (2) ein siebter Schalter (SW₆) in Reihe mit einem Widerstand (R8) angeordnet ist.

6. Verfahren zur Diagnose der Funktionsfähigkeit von Leistungsrelais (7, 8) in einem elektrischen System (100) nach einem der vorangegangenen Ansprüche, wobei die Diagnoseeinrichtung (80) die Schalter in einer vorbestimmten Reihenfolge ansteuert, um so zunächst die Funktionsfähigkeit der Elemente der Diagnoseeinrichtung (80) zu überprüfen, und anschließend die Funktionsfähigkeit der Leistungsrelais (7, 8) überprüft.

## Claims

1. Electrical system (100) comprising at least one high-voltage battery (1), at least one intermediate circuit capacitor (2), and at least two power relays (7, 8), wherein one power relay (7) is arranged between a positive terminal (5) of the high-voltage battery (1) and the intermediate circuit capacitor (2), and the other power relay (8) is arranged between a negative terminal (6) of the high-voltage battery (1) and the intermediate circuit capacitor (2); wherein the electrical system (100) has a galvanically isolated DC/DC converter (70) which is connected to a voltage source in the electrical system (100); wherein the DC/DC converter (70) is designed such that this can transfer electrical energy to a high-voltage side with the intermediate circuit capacitor (2) in order to charge the intermediate circuit capacitor (2), **characterized in that**
the electrical system (100) has a diagnostic device (80) for checking the power relays (7, 8), wherein the diagnostic device (80) has switchable voltage sensors (S_{Bat}, S_{ZK}, S1-S4); wherein one voltage sensor (S_{Bat}) is arranged parallel to the high-voltage battery (1), one voltage sensor (S_{ZK}) is arranged parallel to the intermediate circuit capacitor (2), a respective voltage sensor (S1, S2) is arranged parallel to the power relays (7, 8), one voltage sensor (S3) is arranged between the positive terminal (5) of the high-voltage battery (1) and the negative terminal (4) of the intermediate circuit capacitor (2), and one voltage sensor (S4) is arranged between the negative terminal (6) of the high-voltage battery (1) and a connection between the power relay (7) and the positive terminal (3) of the intermediate circuit capacitor (2).

2. Electrical system according to Claim 1, **characterized in that** a fuse (9) is arranged between the power relay (7) and the positive terminal (3) of the intermediate circuit capacitor (2), wherein the connection for the voltage sensor (S4) is situated between the power relay (7) and the fuse (9).

3. Electrical system comprising at least one high-voltage battery (1), at least one intermediate circuit capacitor (2), and at least two power relays (7, 8), wherein one power relay (7) is arranged between a positive terminal (5) of the high-voltage battery (1) and the intermediate circuit capacitor (2), and the other power relay (8) is arranged between a negative terminal (6) of the high-voltage battery (1) and the intermediate circuit capacitor (2); wherein the electrical system (100) has a galvanically isolated DC/DC converter (70) which is connected to a voltage source in the electrical system (100); wherein the DC/DC converter (70) is designed such that this can transfer electrical energy to a high-voltage side with the intermediate circuit capacitor (2) in order to charge the intermediate circuit capacitor (2), **characterized in that**
the electrical system (100) comprises a diagnostic device (80) for checking the power relays (7, 8), wherein the diagnostic device (80) has a switchable voltage sensor (S_{Bat}) parallel to the high-voltage battery (1), at least one switchable energy source (U_{q}, I_{q}, 1), and also a plurality of switches, wherein
the switchable power source is designed as a voltage source (U_{q}) to which a resistor (R1) is connected in series; wherein a further resistor (R2) and a voltage sensor (5) are arranged parallel to the series connection of resistor (R1) and voltage source (U_{q}); wherein a first switch (SW₂ₐ) is situated between the positive terminal (5) of the high-voltage battery (1) and a positive terminal of the switchable voltage source (U_{q}), a second switch (SW_{2b}) is situated between the positive terminal of the switchable voltage source (U_{q}) and the negative terminal (4) of the intermediate circuit capacitor (2), a third switch (SW₃ₐ) is situated between the negative terminal of the switchable voltage source (U_{q}) and the negative terminal (6) of the high-voltage battery (1), a fourth switch (SW_{3b}) is situated between the negative terminal of the switchable voltage source (U_{q}) and a connection point (25) between power relay (7) and positive terminal (3) of the intermediate circuit capacitor (2), and a fifth switch (SW₄) in series with a resistor (R3) is arranged parallel to a fuse (9) which is situated between the connection point (25) for the fourth switch (SW_{3b}) and the positive terminal (3) of the intermediate circuit capacitor (2).

4. Electrical system comprising at least one high-voltage battery (1), at least one intermediate circuit capacitor (2), and at least two power relays (7, 8), wherein one power relay (7) is arranged between a positive terminal (5) of the high-voltage battery (1) and the intermediate circuit capacitor (2), and the other power relay (8) is arranged between a negative terminal (6) of the high-voltage battery (1) and the intermediate circuit capacitor (2); wherein the electrical system (100) has a galvanically isolated DC/DC converter (70) which is connected to a voltage source in the electrical system (100); wherein the DC/DC converter (70) is designed such that this can transfer electrical energy to a high-voltage side with the intermediate circuit capacitor (2) in order to charge the intermediate circuit capacitor (2), **characterized in that**
the electrical system (100) has a diagnostic device (80) for checking the power relays (7, 8), wherein the diagnostic device (80) has a switchable voltage sensor (SBat) parallel to the high-voltage battery (1), at least one switchable energy source (Uq, Iq, 1), and several switches; wherein the switchable energy source is designed as a power source (I_{q}) parallel to which a voltage sensor (S) is arranged; wherein a first switch (SW₂ₐ) is situated between the positive terminal (5) of the high voltage battery (1) and a positive terminal of the switchable power source (I_{q}), a second switch (SW_{2b}) is situated between the positive terminal of the switchable power source (I_{q}) and a negative terminal (4) of the intermediate circuit capacitor (2), a third switch (SW₃ₐ) is situated between the negative terminal of the switchable power source (I_{q}) and a negative terminal of the high-voltage battery (6), a fourth switch (SW_{3b}) is situated between the negative terminal of the switchable power source (I_{q}) and a connection point (25) between the power relay (7) and a positive terminal (3) of the intermediate circuit capacitor (2), a fifth switch (SW₅) in series with a resistor (R4) is situated between the connection point (25) of the fourth switch (SW_{3b}) and the negative terminal (4) of the intermediate circuit capacitor (2).

5. Electrical system comprising at least one high-voltage battery (1), at least one intermediate circuit capacitor (2), and at least two power relays (7, 8), wherein one power relay (7) is arranged between a positive terminal (5) of the high-voltage battery (1) and the intermediate circuit capacitor (2), and the other power relay (8) is arranged between a negative terminal (6) of the high-voltage battery (1) and the intermediate circuit capacitor (2); wherein the electrical system (100) has a galvanically isolated DC/DC converter (70) which is connected to a voltage source in the electrical system (100); wherein the DC/DC converter (70) is designed such that this can transfer electrical energy to a high-voltage side with the intermediate circuit capacitor (2) in order to charge the intermediate circuit capacitor (2), **characterized in that**
the electrical system (100) has a diagnostic device (80) for checking the power relays (7, 8), wherein the diagnostic device (80) has a switchable voltage sensor (S_{Bat}) parallel to the high-voltage battery (1), at least one switchable energy source (U_{q}, I_{q}, 1), and also several switches; wherein the switchable energy source is the high-voltage battery (1); wherein a first switch (SW₁ₐ) and a second switch (SW_{1b}) are arranged parallel to the power relay (7) at the positive terminal (5), and a third switch (SW₂ₐ) and a fourth switch (SW_{2b}) are arranged parallel to the power relay (8) at the negative terminal (6); wherein a voltage sensor (S) with a resistor (R5) connected in parallel is arranged between the middle taps between the first and second switches, and also between the third and fourth switches; wherein a fifth switch (SW₃) with a resistor (R6) connected in series is arranged parallel to the power relay (7) at the positive terminal (5) of the high-voltage battery (1), and a sixth switch (SW₄) with a resistor (R7) connected in series is arranged parallel to the power relay (8) at the negative terminal (6) of the high-voltage battery (1); wherein a seventh switch (SW₆) in series with a resistor (R8) is arranged between the middle tap between the first and second switches and a positive terminal (3) of the intermediate circuit capacitor (2).

6. Method for diagnosing the functionality of power relays (7, 8) in an electrical system (100) according to any one of the preceding claims, wherein the diagnostic device (80) controls the switches in a predetermined sequence so as to first check the functionality of the elements of the diagnostic device (80) and then to check the functionality of the power relays (7, 8).

## Revendications

1. Système électrique (100), comprenant au moins une batterie haute tension (1), au moins un condensateur de circuit intermédiaire (2) et au moins deux relais de puissance (7, 8), dans lequel un relais de puissance (7) est disposé entre une borne positive (5) de la batterie haute tension (1) et le condensateur de circuit intermédiaire (2) et l'autre relais de puissance (8) est disposé entre une borne négative (6) de la batterie haute tension (1) et le condensateur de circuit intermédiaire (2), dans lequel le système électrique (100) présente un convertisseur CC-CC à séparation galvanique (70), qui est raccordé à une source de tension dans le système électrique (100), dans lequel le convertisseur CC-CC (70) est conçu de manière à pouvoir transmettre de l'énergie électrique pour la charge du condensateur de circuit intermédiaire (2) sur un côté haute tension avec le condensateur de circuit intermédiaire (2),
**caractérisé en ce que**
le système électrique (100) présente un dispositif de diagnostic (80) pour la vérification des relais de puissance (7, 8), dans lequel le dispositif de diagnostic (80) présente des capteurs de tension commutables (S_{Bat}, S_{ZK}, S1-S4), dans lequel un capteur de tension (S_{Bat}) est disposé en parallèle avec la batterie haute tension (1), un capteur de tension (S_{ZK}) est disposé en parallèle avec le condensateur de circuit intermédiaire (2), respectivement un capteur de tension (S1, S2) est disposé en parallèle avec les relais de puissance (7, 8), un capteur de tension (S3) est disposé entre la borne positive (5) de la batterie haute tension (1) et la borne négative (4) du condensateur de circuit intermédiaire (2) et un capteur de tension (S4) est disposé entre la borne négative (6) de la batterie haute tension (1) et une borne entre le relais de puissance (7) et la borne positive (3) du condensateur de circuit intermédiaire (2).

2. Système électrique selon la revendication 1, **caractérisé en ce que,** entre le relais de puissance (7) et la borne positive (3) du condensateur de circuit intermédiaire (2), un fusible (9) est disposé, dans lequel la borne pour le capteur de tension (S4) se trouve entre le relais de puissance (7) et le fusible (9).

3. Système électrique, comprenant au moins une batterie haute tension (1), au moins un condensateur de circuit intermédiaire (2) et au moins deux relais de puissance (7, 8), dans lequel un relais de puissance (7) est disposé entre une borne positive (5) de la batterie haute tension (1) et le condensateur de circuit intermédiaire (2) et l'autre relais de puissance (8) est disposé entre une borne négative (6) de la batterie haute tension (1) et le condensateur de circuit intermédiaire (2), dans lequel le système électrique (100) présente un convertisseur CC-CC à séparation galvanique (70), qui est raccordé à une source de tension dans le système électrique (100), dans lequel le convertisseur CC-CC (70) est conçu de manière à pouvoir transmettre de l'énergie électrique pour la charge du condensateur de circuit intermédiaire (2) sur un côté haute tension avec le condensateur de circuit intermédiaire (2),
**caractérisé en ce que**
le système électrique (100) présente un dispositif de diagnostic (80) pour la vérification des relais de puissance (7, 8), dans lequel le dispositif de diagnostic (80) présente un capteur de tension commutable (S_{Bat}) parallèle à la batterie haute tension (1), au moins une source d'énergie commutable (U_{q}, I_{q}, 1) ainsi que plusieurs commutateurs, dans lequel
la source d'énergie commutable est conçue comme une source de tension (U_{q}), à laquelle une résistance (R1) est branchée en série, dans lequel, parallèle à la connexion en série de la résistance (R1) et de la source de tension (U_{q}), une autre résistance (R2) et un capteur de tension (5) sont disposés, dans lequel un premier commutateur (SW₂ₐ) se trouve entre la borne positive (5) de la batterie haute tension (1) et une borne positive de la source de tension commutable (U_{q}), un deuxième commutateur (SW_{2b}) est disposé entre la borne positive de la source de tension commutable (U_{q}) et la borne négative (4) du condensateur de circuit intermédiaire (2), un troisième commutateur (SW₃ₐ) est disposé entre la borne négative de la source de tension commutable (U_{q}) et la borne négative (6) de la batterie haute tension (1), un quatrième commutateur (SW_{3b}) est disposé entre la borne négative de la source de tension commutable (U_{q}) et un point de raccordement (25) entre le relais de puissance (7) et la borne positive (3) du condensateur de circuit intermédiaire (2) et un cinquième commutateur (SW₄) est disposé en série avec une résistance(R3) en parallèle avec un fusible (9), qui se trouve entre le point de raccordement (25) pour le quatrième commutateur (SW_{3b}) et la borne positive (3) du condensateur de circuit intermédiaire (2).

4. Système électrique, comprenant au moins une batterie haute tension (1), au moins un condensateur de circuit intermédiaire (2) et au moins deux relais de puissance (7, 8), dans lequel un relais de puissance (7) est disposé entre une borne positive (5) de la batterie haute tension (1) et le condensateur de circuit intermédiaire (2) et l'autre relais de puissance (8) est disposé entre une borne négative (6) de la batterie haute tension (1) et le condensateur de circuit intermédiaire (2), dans lequel le système électrique (100) présente un convertisseur CC-CC à séparation galvanique (70), qui est raccordé à une source de tension dans le système électrique (100), dans lequel le convertisseur CC-CC (70) est conçu de manière à pouvoir transmettre de l'énergie électrique pour la charge du condensateur de circuit intermédiaire (2) sur un côté haute tension avec le condensateur de circuit intermédiaire (2),
**caractérisé en ce que**
le système électrique (100) présente un dispositif de diagnostic (80) pour la vérification des relais de puissance (7, 8), dans lequel le dispositif de diagnostic (80) présente un capteur de tension commutable (SBat) parallèle à la batterie haute tension (1), au moins une source d'énergie commutable (Uq, Iq, 1) ainsi que plusieurs commutateurs, dans lequel la source d'énergie commutable est conçue comme une source de courant (I_{q}), à laquelle est raccordé en parallèle un capteur de tension (S), dans lequel un premier commutateur (SW₂ₐ) se trouve entre la borne positive (5) de la batterie haute tension (1) et une borne positive de la source de courant commutable (I_{q}), un deuxième commutateur (SW_{2b}) se trouve entre la borne positive de la source de courant commutable (I_{q}) et une borne négative (4) du condensateur de circuit intermédiaire (2), un troisième commutateur (SW₃ₐ) se trouve entre la borne négative de la source de courant commutable (I_{q}) et une borne négative de la batterie haute tension (6), un quatrième commutateur (SW_{3b}) se trouve entre la borne négative de la source de courant commutable (I_{q}) et un point de raccordement (25) entre le relais de puissance (7) et une borne positive (3) du condensateur de circuit intermédiaire (2), un cinquième commutateur (SW₅) se trouve en série avec une résistance (R4) entre le point de raccordement (25) du quatrième commutateur (SW_{3b}) et la borne négative (4) du condensateur de circuit intermédiaire (2).

5. Système électrique, comprenant au moins une batterie haute tension (1), au moins un condensateur de circuit intermédiaire (2) et au moins deux relais de puissance (7, 8), dans lequel un relais de puissance (7) est disposé entre une borne positive (5) de la batterie haute tension (1) et le condensateur de circuit intermédiaire (2) et l'autre relais de puissance (8) est disposé entre une borne négative (6) de la batterie haute tension (1) et le condensateur de circuit intermédiaire (2), dans lequel le système électrique (100) présente un convertisseur CC-CC à séparation galvanique (70), qui est raccordé à une source de tension dans le système électrique (100), dans lequel le convertisseur CC-CC (70) est conçu de manière à pouvoir transmettre de l'énergie électrique pour la charge du condensateur de circuit intermédiaire (2) sur un côté haute tension avec le condensateur de circuit intermédiaire (2),
**caractérisé en ce que**
le système électrique (100) présente un dispositif de diagnostic (80) pour la vérification des relais de puissance (7, 8), dans lequel le dispositif de diagnostic (80) présente un capteur de tension commutable (S_{Bat}) parallèle à la batterie haute tension (1), au moins une source d'énergie commutable (U_{q}, I_{q}, 1) ainsi que plusieurs commutateurs, dans lequel la source d'énergie commutable est la batterie haute tension (1), dans lequel, parallèle au relais de puissance (7) au niveau de la borne positive (5), un premier commutateur (SW₁ₐ) et un deuxième commutateur (SW_{1b}) sont disposés et, parallèle au relais de puissance (8) au niveau de la borne négative (6), un troisième commutateur (SW₂ₐ) et un quatrième commutateur (SW_{2b}) sont disposés, dans lequel entre les prises médianes entre les premier et deuxième commutateur ainsi qu'entre les troisième et quatrième commutateurs, un capteur de tension (S) est disposé avec une résistance (R5) branchée en parallèle, dans lequel, parallèle au relais de puissance (7) au niveau de la borne positive (5) de la batterie haute tension (1), un cinquième commutateur (SW₃) est disposé avec une résistance (R6) branchée en série et parallèle au relais de puissance (8) au niveau de la borne négative (6) de la batterie haute tension (1), un sixième commutateur (SW₄) est disposé avec une résistance (R7) branchée en série, dans lequel entre la prise médiane entre les premier et deuxième commutateurs et une borne positive (3) du condensateur de circuit intermédiaire (2), un septième commutateur (SW₆) est disposé en série avec une résistance (R8).

6. Procédé de diagnostic du fonctionnement de relais de puissance (7, 8) dans un système électrique (100) selon l'une quelconque des revendications précédentes, dans lequel le dispositif de diagnostic (80) commande les commutateurs dans une séquence prédéfinie, afin de vérifier ainsi le fonctionnement des éléments du dispositif de diagnostic (80) et vérifie ensuite le fonctionnement des relais de puissance (7, 8).
